# EUROPÄISCHE PATENTSCHRIFT

(11) **EP 3 090 992 B1**
(45) Veröffentlichungstag und Bekanntmachung des Hinweises auf die Patenterteilung: **15.08.2018**
(21) Anmeldenummer: 16176221.6
(22) Anmeldetag: 30.04.2014
(51) Int. Cl.: C04B 35/043, C04B 35/565, C04B 35/622, C04B 35/63, C04B 35/66, C04B 35/16, C04B 35/01, C04B 35/20, C04B 35/626

(54) **FEUERFESTER VERSATZ**
REFRACTORY BATCH
MÉLANGE RÉFRACTAIRE

(30) Priorität: 28.06.2013 DE 102013010854
(43) Veröffentlichungstag der Anmeldung: 09.11.2016
(62) Teilanmeldung aus: 14722161.8
(73) Patentinhaber: Refratechnik Holding GmbH, 85737 Ismaning (DE)
(72) Erfinder: Jansen, Helge, 37133 Friedland (DE); Stein, Volker, 37979 Göttingen (DE); Schemmel, Thomas, 49668 Meerbusch (DE)
(74) Vertreter: Patent- und Rechtsanwälte Dr. Solf & Zapf

(56) Entgegenhaltungen:
- CN-A- 101 328 070
- CN-A- 101 607 826
- DE-U1-202012 012 495
- JP-A- S 495 407
- US-A- 4 497 901

## Beschreibung

Die Erfindung betrifft einen feuerfesten Versatz nach ISO/R 836, DIN 51060, in Form eines mineralischen Gemisches, ein Verfahren zur Herstellung eines feuerfesten Erzeugnisses unter Verwendung des Versatzes und die durch das Verfahren hergestellten gebrannten und ungebrannten Formsteine, die in situ in hohem Maße widerstandsfähig sind gegen den Angriff fayalitischer Schlacken (Eisensilikatschlacken) und Sulfaten und beständig gegen Buntmetallschmelzen, insbesondere gegen Kupferschmelze sind.

Fayalitische Schlacken entstehen z.B. bei der Herstellung von Kupfer aus Kupferkies (CuFeS₂). Kupferkies wird geröstet, woraus sogenannter Kupferstein resultiert enthaltend Kupfersulfid (Cu₂S) und Eisenverbindungen, z.B. FeS und Fe₂O₃. Der Kupferstein wird zu Rohkupfer weiterverarbeitet, wobei glutflüssiger Kupferstein unter Luftzufuhr und Zusatz von SiO₂, z.B. in Form von Quarz in einem Konverter behandelt wird. Dabei entsteht eine fayalitische Schlacke, die hauptsächlich das Mineral Fayalit (2FeO·SiO₂) enthält und Rohkupferoxid (Cu₂O).

Man kleidet derzeit die Konverter zur Herstellung von Rohkupfer, z.B. einen Pierce-Smith-Konverter, feuerseitig hauptsächlich mit gebrannten Magnesiachromiterzeugnissen aus (z. B. DE 14 71 231 A1). Diese feuerfesten Erzeugnisse widerstehen aber dabei nur ungenügend dem Angriff von Sulfaten, die aus der Oxidation der Sulfide z.B. in Form von Magnesiumsulfat resultieren. Magnesiachromitsteine haben außerdem nur begrenzte bzw. ungenügende Hochtemperatur-Antiwetting-Eigenschaften und sie weisen einen ungenügenden Penetrationswiderstand gegen heiße Buntmetall- insbesondere Kupferschmelzen auf. Magnesiachromitsteine werden auch in Schmelzaggregaten für die Erzeugung anderer Nichteisenmetalle (Buntmetalle wie Ni, Pb, Sn, Zn) eingesetzt und ergeben dort gleich gelagerte Probleme.

Die DE 20 2012 012 495 U1 offenbart einen feuerfesten Versatz, insbesondere für die Auskleidung von Buntmetall-Schmelzaggregaten, vorzugsweise für die Auskleidung von Kupferschmelzkonvertern, hauptsächlich enthaltend mindestens 30 Gew.-% eines grobkörnigen Olivinrohstoffs mit Forsteritgehalten von mindestens 70 Gew.-% und Korngrößen von über 0,1 mm, mindestens 35 Gew.-% Magnesia in Mehlform mit Korngrößen von ≤ 1 mm, mindestens 5 Gew.-% Siliciumcarbid in Mehlform mit Korngrößen von ≤ 1 mm, optional maximal 10 Gew.-% einer trockenen feinteiligen Kieselsäure, optional maximal 10 Gew.-% mindestens eines weiteren Zusatzmittels für feuerfeste Erzeugnisse wie Antioxidantien, Rest auf 100 Gew.-% jeweils mindestens einen der anderen Feststoffe. Der Versatz enthält zudem mindestens 2 Gew.-% eines flüssigen Bindemittels in Form eines alkaliarmen, vorzugsweise alkalifreien Kieseslsols, berechnet auf die trockenen Feststoffe.

In der US 4,497,901 A ist ein Forsterit-Kohlenstoff-Feuerfestmaterial offenbart, das im Wesentlichen aus 5 bis 50 Gew.-% Forsteritmaterial, 5 bis 30 Gew.-% kohlenstoffhaltigem Material, 0,5 bis 10 Gew.-% Siliciumcarbid und Magnesiumoxid-Feuerfestmaterial besteht.

Die CN 101328070 A betrifft ein Forsterit-Kohlenstoff-haltiges Feuerfestmaterial und ein Verfahren zu dessen Herstellung. Das Verfahren umfasst Mischen von 25 bis 40 Gew.-% Magnesiumoxidteilchen mit einer Korngröße von 3 bis 1 mm, 20 bis 35 Gew.-% Magnesiumoxidteilchen mit einer Korngröße von 1 bis 0 mm, 5 bis 40 Gew.-% Forsterit-Kohlenstoff-Mischfeinpulver und 0 bis 35 Gew.-% feines Magnesiumoxidpulver. Weiter umfasst das Verfahren Zugabe von 4 bis 10 Gew.-% eines Bindemittels, 10 bis 30 Minuten rühren oder vermahlen, Trocknen nach dem Pressformen, Sintern bei einer reduzierenden Atmosphäre mit einer Sintertemperatur von 1450-1700 °C und einer Wärmeerhaltungszeit von 4 bis 8 Stunden.

Die CN 101607826 A betrifft ein durch Forsterit-Kohlenstoff synthetisiertes MgO-SiC-C-Feuerfestmaterial und ein Verfahren zu dessen Herstellung. Gemäß dem Verfahren werden Forsterit-Mineralpulver und industrielles Kohlenstoffpulver in einem Molverhältnis von 1:(1-5) gemischt, dann wird das Gemisch mit 4 bis 10 Gew.-% Bindemittel versetzt, 10 bis 30 Minuten lang gerührt oder gemahlen, gepresst, um geformt und getrocknet zu werden. Schließlich wird die Mischung unter Ar-Gasbedingung bei einer Sintertemperatur von 1530 bis 1800 °C unter Wärmeerhaltung für 2 bis 8 Stunden gesintert.

Die JP 495407 betrifft ein Magnesia-Forsterit-Feuerfestprodukt für Gießpfannen, hergestellt aus Forsteritmaterial, Magnesiumoxidklinker, Siliziumkarbid und Bindemittel. Die Herstellung erfolgt durch Mischung von 10 bis 50 Gew.-% Forsteritmaterial, 30 bis 70 Gew.-% Magnesiumoxidklinker, 5 bis 20 Gew.-% Siliziumkarbid und einem anorganischen oder organischen Bindemittel, anschließender Formgebung und Trocknung mit oder ohne Wärmebehandlung.

Aufgabe der Erfindung ist, einen feuerfesten mineralischen Versatz für feuerfeste Erzeugnisse und feuerfeste Erzeugnisse daraus zu schaffen, die bei Verwendung in einer feuerfesten Auskleidung gute Antiwetting-Eigenschaften gegen Buntmetallschmelzen, insbesondere gegen Kupferschmelze haben, einen verbesserten Penetrationswiderstand gegen fayalitische Schlacken ergeben und eine bessere Beständigkeit bei einem Sulfatangriff bei Einsatztemperaturen gewährleisten als die auf diesem Feuerfestsektor bisher verwendeten feuerfesten Erzeugnisse.

Diese Aufgabe der Erfindung wird durch einen feuerfesten Versatz gemäß Anspruch 1 gelöst, der über 90 Gew.-%, aus einem Trockenstoffgemisch aus Olivinrohstoff, Magnesiamehl (MgO-Mehl), Siliciumcarbidmehl (SiC-Mehl), einer trockenen feinteiligen Kieselsäure und einem an sich bekannten Bindemittel für feuerfeste Erzeugnisse ausgebildet ist.

Des Weiteren kann ein trockener, erfindungsgemäßer Versatz, bis zu 4 Gew.-% für feuerfeste Produkte üblicherweise verwendete Antioxidantien und/oder andere für Feuerfesterzeugnisse üblicherweise verwendete Zusatzstoffe; bis zu 2 Gew.-% eines Zusatzmittels für die Herstellung feuerfester Erzeugnisse wobei aber das Mengenverhältnis der Bestandteile Olivin, MgO, SiC und SiO₂ erhalten bleiben soll.

Der natürlich vorkommende, auf dem Markt erhältliche Olivinrohstoff wird erfindungsgemäß als auf dem Sachgebiet sogenanntes Grobkorngranulat eingesetzt und soll erfindungsgemäß möglichst 100 Gew.-%, mindestens jedoch 70 Gew.-% des Minerals Forsterit aufweisen. Der Rest kann das Mineral Fayalit und/oder können andere bekannte Verunreinigungen des Rohstoffs wie Enstatit und/oder Monticellit und/oder Merwinit sein. Es liegt im Rahmen der Erfindung, einen synthetisch hergestellten, reinen Forsteritwerkstoff allein oder in Kombination mit einem natürlichen Olivinrohstoff zu verwenden. Soweit im Rahmen der Erfindung von Olivinrohstoff die Rede ist, betrifft dies auch den synthetischen Forsteritwerkstoff.

Die verwendete Korngröße des Olivinrohstoffgranulats liegt im Grobkornbereich von über 0,1 mm, z.B. zwischen 0,1 und 6, insbesondere zwischen 1 und 6 mm, wobei das Granulat z.B. eine Gaußsche Korngrößenverteilung aufweist.

Der Olivinrohstoff wird in Mengen von 3 bis 74 Gew.-%, insbesondere von 21 bis 63,7 Gew.-%, im erfindungsgemäßen Versatzgemisch eingesetzt.

Magnesia wird feinteilig in Form eines Mehls bzw. Pulvers mit Korngrößen 100 Gew.-% ≤ 1 mm verwendet. Als Magnesia wird z.B. Schmelzmagnesia und/oder Sintermagnesia und/oder synthetische totgebrannte oder kaustische Magnesia eingesetzt. (Die Begriffe "Mehl" und "Pulver" werden im Rahmen der Erfindung als gleiche Begriffe mit gleichem Begriffsinhalt verstanden und sind auf dem Sachgebiet bekannt. Man versteht darunter i.d.R. trockene lose Haufwerke aus festen Partikeln ≤ 1 mm Partikelgröße.)

Der MgO-Gehalt der Magnesia soll vorzugsweise > 90 Gew.-%, insbesondere > 95 Gew.-% betragen. Der Rest sind übliche Verunreinigungen wie Silikate und/oder Eisenoxid.

Die MgO-Mehle weisen z.B. ebenfalls eine Gaußsche Korngrößenverteilung auf.

Das MgO-Mehl wird im trockenen Versatzgemisch in Mengen von 25 bis 49 Gew.-%, insbesondere von 30 bis 43 Gew.-%, verwendet.

Siliciumcarbid (SiC) ist auf dem Markt als synthetisches Produkt mit hohem Reinheitsgrad und in verschiedenen Körnungen und Korngrößenverteilungen erhältlich und wird erfindungsgemäß in Pulverform bzw. in Mehlform mit Korngrößen 100 Gew.-% ≤ 1 mm verwendet. Die Korngrößenverteilung entspricht vorzugsweise einer Gaußschen Kornverteilung.

Das SiC-Pulver wird z.B. mit einer Reinheit von > 90 Gew.-%, insbesondere > 94 Gew.-% an SiC eingesetzt. Die verwendete Menge im trockenen Versatzgemisch beträgt von 0,9 bis 14 Gew.-%, insbesondere von 5 bis 14 Gew.-%.

Die feinteilige, trockene Kieselsäure ist eine Kieselsäure, die mit dem MgO des Magnesiamehls in einem wässrigen Milieu unter Ausbildung von Magnesiumsilikathydratphasen reagiert und z.B. Magnesiumsilikathydratgel und/oder Magnesiumsilikathydratkristallite und/oder Magnesiumsilikathydratkristalle bildet. Der SiO₂-Gehalt der feinteiligen trockenen Kieselsäure liegt vorzugsweise über 90 Gew.-%, insbesondere über 94 Gew.-%. Der erfindungsgemäße Versatz enthält erfindungsgemäß im Gemisch keine flüssigen wasserhaltigen Kieselsäuren wie Kieselsol oder Kieselgel oder Wasserglas od. dgl. Es hat sich in überraschender Weise ergeben, dass trockene feinteilige Kieselsäure bei Zutritt von Wasser zum erfindungsgemäßen Versatz schneller mit dem MgO der Magnesia MSH-Phasen bildet und schneller erhärtet und höhere Kaltdruckfestigkeiten ergibt. Warum das so ist, ist noch nicht geklärt.

Die Kieselsäure ist so feinteilig zu wählen, dass in einer Wasser enthaltenden Versatzfrischmasse, die durch Zugabe von Wasser zu einem trockenen Versatz und Mischen entsteht, eine Reaktion zwischen dem MgO der Magnesiateilchen und Teilchen der Kieselsäure stattfindet und sich Magnesiumsilikathydratphasen - im Folgenden auch MSH-Phasen genannt - z.B. als Gel und/oder Kristallite und/oder Kristalle bilden, die nach Art einer hydraulischen Abbindung eine Verfestigung der wasserhaltigen Masse bewirken. Vorzugsweise wird dafür der Versatz so zusammengestellt, dass sich im wässrigen Milieu, also nach Zugabe von Wasser zum Versatz, ein pH-Wert über 7, insbesondere über 10 einstellt.

Dementsprechend eignen sich für die Reaktion zu MSH-Phasen z.B. kristalline Quarzmehle einer Feinheit der Quarzteilchen unter 500, insbesondere unter 200 µm.

Des Weiteren sind für die Erfindung als trockene, feinteilige Kieselsäuren besonders geeignet:
- Silikastaub
   Silikastaub ist ein sehr feines, nicht kristallines amorphes SiO₂-Pulver, das in einem Lichtbogenofen entsteht als Nebenprodukt bei der Herstellung von elementarem Silicium oder von Siliciumlegierungen. Es wird z.B. unter dem Handelsnamen Silikastaub oder Mikrosilica auf dem Markt angeboten und weist i.d.R. über 85 Gew.-% SiO₂ auf. Die Partikelgröße des Silikastaubs - auch Silikarauch genannt - liegt i.d.R. unter 1 mm. Die englische Bezeichnung ist "silica fume".
- Pyrogene Kieselsäure
   Pyrogene Kieselsäuren sind sehr reine amorphe SiO₂-Pulver mit SiO₂-Gehalten z.B. bis 99 Gew.-% und mit i.d.R. Teilchengrößen z.B. zwischen 5 und 50 nm und mit hoher spezifischer Oberfläche z.B. zwischen 50 und 600 m²/g. Diese Kieselsäuren werden durch Flammhydrolyse hergestellt. Pyrogene Kieselsäure wird auf dem Markt z.B. unter dem Handelsnamen Aerosil angeboten. Die englische Bezeichnung ist "fumed silica".
- Gefällte Kieselsäure
   Bei der Herstellung von gefällter Kieselsäure auf nassem Wege geht man von Alkalisilikatlösungen aus, aus denen durch Zusatz von Säure sehr reine amorphe Kieselsäuren ausgefällt werden (86 - 88 Gew.-% SiO₂; 10 - 12 Gew.-% Wasser). Die Teilchengröße liegt zwischen 1 und 200 µm und die spezifische Oberfläche zwischen 10 und 500 m²/g. Gehandelt werden gefällte Kieselsäuren z.B. unter dem Handelsnamen "Sipernat" oder "Ultrasil". Trotz des Wassergehalts sind diese Kieselsäuren nicht flüssig, sondern trocken und pulvrig.

Im Rahmen der Erfindung wird mindestens eine der oben genannten Kieselsäuren verwendet. Zweckmäßigerweise werden die Kieselsäuren bezüglich ihrer Reaktionsfähigkeit mit dem MgO des Magnesiamehls ausgewählt und dafür gesorgt, dass die Kieselsäure möglichst vollständig mit MgO beim Erhärten reagiert.

Die feinteilige trockene Kieselsäure wird im trockenen Versatzgemisch von 0,1 bis 10, insbesondere von 0,5 bis 5 Gew.-% verwendet.

Den zu 100 Gew.-% errechneten erfindungsgemäßen oben beschriebenen trockenen Versätzen wird gemäß einer vorteilhaften, nicht erfindungsgemäßen Variante lediglich noch Wasser beigemengt zur Herstellung von feuerfesten Erzeugnissen.

Erfindungsgemäß werden somit folgende Versätze in Gew.-% zusammengestellt:

| | | | | | | | |
|---|---|---|---|---|---|---|---|
| Olivinrohstoff: | 3 | bis | 74, | insbesondere | 24 | bis | 63,7 |
| Magnesiamehl: | 25 | bis | 49, | insbesondere | 30 | bis | 45 |
| SiC-Mehl: | 0,9 | bis | 14, | insbesondere | 5 | bis | 14 |
| feinteilige Kieselsäure: | 0,1 | bis | 10, | insbesondere | 0,5 | bis | 5 |
| Antioxidantien: | 0 | bis | 4, | insbesondere | 0,5 | bis | 2,5 |
| Zusätzliches feuerfestes | | | | | | | |
| Rohstoffgranulat: | 0 | bis | 4, | insbesondere | 0,1 | bis | 3,5 |
| feuerfester Zusatzstoff: | 0 | bis | 4, | insbesondere | 0,1 | bis | 3,5 |
| Zusatzmittel für feuerfeste | | | | | | | |
| Erzeugnisse: | 0 | bis | 2, | insbesondere | 0,1 | bis | 1,5 |
| Bindemittel für feuerfeste | | bis 10, berechnet auf die Trockensub-Erzeugnisse in trockener stanz des Versatzes | | | | | |
| Form oder beigepackt in flüssiger Form: | | | | | | | |

Erfindungsgemäß weist der Versatz dabei beigepackt in flüssiger Form mindestens ein wasserhaltiges Bindemittel für feuerfeste Erzeugnisse aus der Gruppe Ligninsulfonat, Magnesiumsulfat und Ethylsilikat und/oder mindestens ein Bindemittel aus der Gruppe Pech und/oder Teer und Kunstharze auf.

Vorzugsweise ist die Kieselsäure mindestens eine der oben genannten amorphen Kieselsäure.

Die Mengen der Reaktionspartner MgO und SiO₂ in den vorteilhaften, nicht erfindungsgemäßen Versätzen werden so gewählt, dass bei Wasserzusatz von 1 bis 10, insbesondere von 2,5 bis 6 Gew.-%, bezogen auf die Trockensubstanz des Versatzes in einem Zeitraum zwischen 6 und 120, insbesondere zwischen 8 und 12 Stunden im Temperaturbereich von 50 bis 200, insbesondere von 100 bis 150°C Kaltdruckfestigkeiten von 40 bis 160, insbesondere von 60 bis 150 MPa gewährleistbar sind.

Bevorzugt wird vorgesehen, dass das reaktionsfähige MgO des Magnesiamehls mengenmäßig überwiegend zur reaktionsfähigen feinteiligen Kieselsäure vorliegt. Daraus soll resultieren, dass sich nach Wasserzugabe MgO-reiche MSH-Phasen bilden, die bei Einwirkung hoher Temperaturen bis z. B. 1350°C Forsterit (2 MgO ▪ SiO₂) bilden können, der den Forsteritanteil des Olivinrohstoffs erhöht.

Zweckmäßig sind überwiegende Massenverhältnisse MgO zu SiO₂ bis 500. Insbesondere liegt das Verhältnis zwischen 1,2 und 100, vorzugsweise zwischen 1,34 und 50, ganz besonders vorzugsweise zwischen 1,34 und 35.

Aus den Trockenversätzen ohne flüssiges Bindemittel werden vorteilhafte, nicht erfindungsgemäße feuerfeste Erzeugnisse nur nach Zusatz von Wasser hergestellt, wobei eine Mischung mit Wassermengen, bezogen auf die Masse des trockenen Versatzes 1 bis 10 Gew.-%, vorzugsweise 2,5 bis 6,0 Gew.-% beträgt.

Wasserhaltige sogenannte Frischmassen werden mit Wassergehalten z.B. zwischen 1 und 5, insbesondere zwischen 1,5 und 3 Gew.-% mit üblichen Pressverfahren zu geformten Steinrohlingen gepresst. Die geformten Steine lässt man im Temperaturbereich zwischen 15 und 200, vorzugsweise zwischen 50 und 200, insbesondere zwischen 100 und 150°C aushärten und trocknen, wobei MSH-Phasen gebildet werden. Nach dem Aushärten weisen die Steine relativ hohe Festigkeiten auf und sind handhabbar, so dass daraus eine feuerfeste Auskleidung gemauert werden kann. Die Steine weisen vorzugsweise Kaltdruckfestigkeiten z.B. zwischen 40 und 100, insbesondere zwischen 60 und 80 MPa, auf.

Die geformten und durch Bildung von MSH-Phasen erhärteten bzw. verfestigten und getrockneten Steine können keramisch gebrannt werden, so dass aus den MSH-Phasen vorzugsweise Sinterprodukte, z.B. aus Forsterit entstehen und Sinterbrücken aus z.B. Forsterit zwischen den Olivinkörnern bzw. Olivinteilchen und/oder MgO-Mehlteilchen und/oder SiO₂-Teilchen bilden. Das keramische Brennen wird vorzugsweise im Temperaturbereich von 400 bis 1400, insbesondere von 600 bis 1200°C und während einer Zeitdauer von 1 bis 24, insbesondere von 4 bis 12 Stunden durchgeführt, wobei vorteilhaft ist, in reduzierender Atmosphäre zu brennen.

Für das Pressen von Steinen und die Ausbildung von MSH-Phasen reicht es aus, einem Versatz von 1 bis 5, insbesondere von 1,5 bis 3 Gew.-% Wasser zuzusetzen. Es können auch an sich bekannte Fließmittel dem wasserhaltigen Gemenge zugesetzt werden, um die Bildsamkeit des Gemenges zu erhöhen. Derartige Fließmittel sind dem Fachmann bekannt. Sie werden i.d.R. in Mengen von 0,01 bis 2, insbesondere von 0,1 bis 1,5 Gew.-% zugesetzt.

Mit höheren Wassergehalten, z.B. von 4 bis 10 Gew.-%, insbesondere von 4 bis 6 Gew.-% werden können aus den trockenen Versätzen bildsame Gießmassen oder Stampfmassen erzeugt und daraus mittels Formgebung in Formen feuerfeste monolithische vorgeformte Fertigteile hergestellt werden. Die Verfestigung durch MSH-Phasenbildung erfolgt dabei z.B. bei Raumtemperaturen und die Trocknung mit einer entsprechenden erhöhten Temperaturbehandlung. Die Festigkeitsentwicklung der geformten Masse entspricht der der geformten und getemperten Steine. In der Regel liegen die Festigkeiten jedoch sogar höher. Mit dem Begriff "Tempern" soll im Rahmen der vorliegenden Erfindung die Temperaturbehandlung der wasserhaltigen Gemenge im angegebenen Temperaturbereich einschließlich Trocknung gemeint sein.

Ein vorteilhaftes, nicht erfindungsgemäßes Erzeugnis wird zweckmäßig hergestellt, indem aus einem Versatz mit zumindest den Trockenstoffen Olivinrohstoff, Magnesia, SiC und Kieselsäure und Wasser mit geeigneten Mischern ein homogenes Gemenge mit vorgegebener plastischer bzw. bildsamer oder fließfähiger Verarbeitbarkeit erzeugt wird. Diese bildsame oder fließfähige Masse des Gemenges kann vor Ort zur Auskleidung von Schmelzkonvertern verwendet werden. Aus dem Gemenge können - wie bereits beschrieben - aber auch monolithisch geformte Fertigteile oder gepresste Steine erzeugt werden; letztere können ungebrannt oder keramisch gebrannt zur Auskleidung von z. B. Schmelzkonvertern verwendet werden.

Die Erfindung verwendet somit einen trockenen Versatz ausschließlich aus oder z. B. hauptsächlich, d. h. z. B. über 90 Gew.-%, insbesondere über 95 Gew.-% aus Olivingranulat, MgO-Mehl und SiC-Mehl und einer feinteiligen, trockenen SiO₂-Komponente, insbesondere in Form von Mikrosilika. Der jeweilige Rest kann z. B. mindestens ein anderes feuerfestes Rohstoffgranulat wie Magnesiachromit, Magnesiumspinelle, Spinelle, Chromoxid, Zirkonoxid, Siliciumnitrid, Zirkon und/oder mindestens ein feuerfester Zusatzstoff wie Magnesiachromit, Magnesiumspinelle, Spinelle, Chromoxid, Zirkonoxid, Siliciumnitrid, Zirkon und/oder mindestens ein Zusatzmittel wie Verflüssiger und/oder Abbinderegulatoren sein.

Beispielsweise werden in vorteilhafter, nicht erfindungsgemäßer Weise aus einem oben angegebenen wasserhaltigen Versatzgemenge durch Pressen gepresste oder ungepresste Formkörper hergestellt und die Formkörper bis auf Restfeuchten vorzugsweise zwischen 0,1 und 2 Gew.-% gebracht oder die Formkörper werden nach einer weiteren Ausführungsform zusätzlich keramisch in einem keramischen Brennofen gebrannt bei Temperaturen zwischen vorzugsweise 400 und 1400, insbesondere zwischen 600 und 1200°C in oxidierender, insbesondere aber in reduzierender Atmosphäre für eine Zeitdauer vorzugsweise zwischen 1 und 24, insbesondere zwischen 4 und 12 Stunden. Die Brennbedingungen werden dabei erfindungsgemäß so gewählt, dass die Bestandteile Olivinrohstoff und SiC während des Brennens möglichst nicht oder nur zu einem geringen Anteil miteinander reagieren, damit diese Bestandteile in situ im Schmelzaggregat, z. B. im Konverter beim Angriff einer Schmelze und/oder Schlacke für die erfindungsgemäße Gewährleistung der Feuerfestigkeit, insbesondere durch Antiwettingwirkung und chemische Beständigkeit gegen Schmelze und Schlackenbestandteile zur Verfügung stehen.

Mit den ungebrannten und gebrannten Formkörpern können Auskleidungen von Buntmetallschmelzkonvertern erstellt werden, die den bisherigen Auskleidungen bezüglich Infiltrations- und Korrosionswiderstand gegen Buntmetallschmelzen und nichtmetallischen Schmelzen (flüssige Schlacken) der Buntmetallverhüttung überlegen sind. Insbesondere zeigt sich die Überlegenheit der feuerfesten Erzeugnisse in Kupferschmelzkonvertern, z. B. in einem Pierce-Smith-Konverter (PS-Konverter).

Die ungebrannten gepressten getrockneten Formkörper weisen z. B. die folgenden Eigenschaften auf:

| | | |
|---|---|---|
| Rohdichte: | 2,65 | bis 2,80 kg/m³ |
| Kaltdruckfestigkeit: | 40 | bis 100, insbesondere 60 bis 80 MPa. |

Die gebrannten Formkörper weisen z. B. die folgenden Eigenschaften auf:

| | | |
|---|---|---|
| Rohdichte: | 2,55 | bis 2,75 kg/m³, |
| Kaltdruckfestigkeit: | 30 | bis 80, insbesondere 40 bis 70 MPa. |

Die Fertigteile weisen z. B. die folgenden Eigenschaften auf:

| | | |
|---|---|---|
| Rohdichte: | 2,55 | bis 2,75 kg/m³, |
| Kaltdruckfestigkeit: | 40 | bis 180, insbesondere 50 bis 150 MPa. |

Die Erzeugnisse eignen sich speziell für den Einsatz in PS-Konvertern für die Kupfererzeugung, sind aber auch mit Vorteilen gegenüber den üblichen feuerfesten Erzeugnissen in anderen Anwendungen, bei denen fayalitische Schlacken und dünnflüssige Buntmetallschmelzen auftreten wie das praktisch in der gesamten Buntmetallindustrie der Fall ist, mit den beschriebenen Vorteilen verwendbar.

Das erfindungsgemäße Konzept beruht darauf, dass basierend auf Olivin-Grobkorn sowie SiC- und MgO-Feinkorn bzw. Mehlkorn sich das Gleichgewicht im Stein zwischen den Reaktionsstoffen aus dem Stein und der Schlacke erst bei Schmelzprozesstemperaturen über 1000°C, z. B. zwischen 1200 und 1350°C einstellt. Bei diesen Temperaturen ist SiC trotz oxidierender Schmelzprozessbedingungen bezüglich Antiwettingwirkung noch voll wirksam. MgO reagiert mit dem entstehenden Oxidationsprodukt des SiC, nämlich dem SiO₂, zu weiterem Forsterit. MgO wird erfindungsgemäß im stöchiometrischen Überschuss zu für eine Reaktion verfügbarem SiO₂ gewählt, um die Bildung von Enstatit, das nicht feuerfest ist, zu vermeiden. Diese Reaktionen in situ während des Schmelzprozesses versiegeln den Stein unmittelbar feuerseitig und behindern die Penetration durch die sehr dünnflüssige Metallschmelze, z. B. Kupferschmelze. Das SiC wirkt zudem als Schlackenbremse. In Kontakt mit den allgegenwärtigen Fayalitschlacken reagiert außerdem das überschüssige MgO zusammen mit dem Forsterit zu Olivin-Mischkristallen. Die Solidus-Temperatur steigt dadurch an, d. h. das Reaktionsprodukt Schlacke-Stein friert auf, d. h. führt zu einem Ansteifen der Schlacke und die Korrosionsreaktion wird gestoppt oder zumindest jedoch stark reduziert.

Nach der vorteilhaften, nicht erfindungsgemäßen Variante lässt man somit die gepressten Formkörper, die z. B. einen Wassergehalt zwischen 1 und 5, insbesondere zwischen 1,5 und 3 aufweisen, erhärten, wobei sich die MSH-Phasen bilden, die die Erhärtung bewirken. Die Erhärtungszeit ist temperaturabhängig. Man lässt die gepressten Formkörper zweckmäßigerweise 6 bis 120, insbesondere 24 bis 96 Stunden erhärten und trocknen im Temperaturbereich zwischen 50 und 200, insbesondere zwischen 100 und 150°C bis zu Restfeuchten zwischen 0,1 und 4,5, insbesondere zwischen 0,1 und 2,5 Gew.-% Wassergehalt in einem geeigneten Trocknungsaggregat. Es werden dabei Kaltdruckfestigkeiten zwischen 40 und 100, insbesondere zwischen 60 und 80 MPa erzielt.

Die vorteilhaft herstellbaren nicht gepressten, in Formen gegossenen und ggf. vibrierten Frischmassen für monolithische Fertigbauteile weisen Wassergehalte zwischen 4 und 10, insbesondere zwischen 4 und 6 Gew.-% auf. Sie werden in Formen eingebracht und ggf. vibriert. Man lässt sie z. B. an der Luft zwischen 15 und 35°C erhärten und im oben für die gepressten Formkörper angegebenen Temperaturbereich trocknen bis auf Restfeuchten wie bei den gepressten Formkörpern. Dabei erzielt man Kaltdruckfestigkeiten zwischen 40 und 180, insbesondere zwischen 50 und 150 MPa.

Nach einer ersten Ausführungsform der Erfindung wird anstelle von Wasser oder in Kombination damit mindestens ein an sich bekanntes wasserhaltiges Bindemittel für feuerfeste Erzeugnisse aus der folgenden Gruppe Ligninsulfonat, Magnesiumsulfat und Ethylsilikat verwendet in einer Menge berechnet auf die Trockensubstanz eines Versatzes von z. B. 2 bis 5 Gew.-% für gepresste Erzeugnisse und von z. B. 4 bis 10 Gew.-% für Fertigbauteile und Gießmassen. Der Wasseranteil dieser Bindemittel trägt dabei zur oben beschriebenen MSH-Phasenbildung bei.

Des Weiteren kann im Rahmen einer weiteren Ausführungsform der Erfindung anstelle von Wasser ein an sich bekanntes Bindemittel für feuerfeste Erzeugnisse aus der Gruppe Pech und/oder Teer und der bekannten Kunstharze wie Phenol-Formaldehydharze verwendet werden jeweils in Mengen von z. B. 2 bis 5 Gew.-% berechnet wie oben. Durch die Anwesenheit von MgO und SiO₂ im Versatz bildet sich der zusätzliche Forsterit erst bei höheren Temperaturen in situ.

Die Erfindung schafft somit folgende neue feuerfeste Versätze und deren Verwendung.

Die Erfindung betrifft im Wesentlichen einen Versatz aus mineralischen, feuerfesten Werkstoffen für eine Auskleidung von Buntmetall-Schmelzaggregaten, vorzugsweise für die Auskleidung von Kupferschmelzkonvertern, enthaltend über 90 Gew.-%, insbesondere über 95 Gew.-% eines Gemisches aus folgenden Bestandteilen oder ganz vorzugsweise bestehend aus folgenden Bestandteilen:
- 3 bis 74 Gew.-% mindestens eines grobkörnigen Olivinrohstoffs mit Forsteritgehalten von mindestens 70 Gew.-%, insbesondere mindestens 90 Gew.-%, vorzugsweise mindestens 100 Gew.-%, aufweisend Korngrößen von 100 Gew.-% über 0,1 mm
- 25 bis 49 Gew.-% mindestens einer Magnesia in Mehlform, mit Korngrößen von 100 Gew.-% ≤ 1 mm
- 0,9 bis 14 Gew.-% mindestens eines Siliciumcarbids (SiC) in Mehlform, mit Korngrößen von 100 Gew.-% ≤ 1 mm
- 0,1 bis 10 Gew.-% mindestens einer feinteiligen trockenen pulverförmigen Kieselsäure, vorzugsweise mit Teilchengrößen ≤ 500 µm
- 0 bis 4 Gew.-% mindestens eines an sich bekannten Antioxidans für feuerfeste Erzeugnisse
- 0 bis 4 Gew.-% mindestens eines an sich bekannten zusätzlichen feuerfesten Rohstoffgranulats, vorzugsweise mit Korngrößen von 50 Gew.-%, insbesondere von 80 Gew.-%, vorzugsweise von 100 Gew.-% über 0,1 mm
- 0 bis 2 Gew.-% mindestens eines an sich bekannten Zusatzmittels für die Herstellung feuerfester Erzeugnisse aus Versätzen
- 0 bis 4 Gew.-% mindestens eines an sich bekannten Zusatzstoffes aus feuerfesten Werkstoffen, insbesondere in Mehlform, vorzugsweise auch in Form von sogenanntem Mittelkorn und/oder von sogenanntem Grobkorn
- bis 10 Gew.-%, berechnet auf die Trockensubstanz des Versatzes, mindestens eines an sich bekannten Bindemittels für feuerfeste Erzeugnisse in trockener Form oder beigepackt in flüssiger Form
wobei der Versatz zumindest ein wasserhaltiges Bindemittels für feuerfeste Erzeugnisse aus der Gruppe Ligninsulfonat, Magnesiumsulfat und Ethylsilikat und/oder mindestens ein Bindemittel aus der Gruppe Pech und/oder Teer und Kunstharze aufweist.

Es liegt im Rahmen der Erfindung, diesen erfindungsgemäßen Versatz zu kombinieren mit mindestens einem Merkmal der folgenden Merkmale:
- Der Versatz enthält über 90 Gew.-%, insbesondere über 95 Gew.-% eines der folgenden Gemische, vorzugsweise bestehend aus einem der folgenden Gemische:
   21 bis 63,7 Gew.-% des mindestens einen Olivinrohstoffs
   30 bis 43 Gew.-% der mindestens einen Magnesia
   5 bis 15 Gew.-% des mindestens einen Siliciumcarbids
   0,5 bis 5 Gew.-% der mindestens einen Kieselsäure
   0,5 bis 2,5 Gew.-% des mindestens einen Antioxidans
   0,1 bis 3,5 Gew.-% des mindestens einen zusätzlichen feuerfesten Rohstoffgranulats
   0,1 bis 1,5 Gew.-% des mindestens einen Zusatzmittels
   0,1 bis 3,5 Gew.-% des mindestens einen Zusatzstoffs
   bis 5 Gew.-%, berechnet auf die Trockensubstanz des Versatzes, des mindestens einen genannten Bindemittels
- Der Olivinrohstoff ist ein natürlicher Olivinrohstoff und/oder ein synthetisch hergestellter Forsteritwerkstoff mit Kornbändern des Olivinrohstoffs im sogenannten Grobkornbereich z.B. zwischen 0,1 und 6, insbesondere zwischen 1 und 6 mm und vorzugsweise einer Gaußschen Kornverteilung.
- Der MgO-Gehalt des Magnesiamehls liegt über 90 Gew.-%, insbesondere über 95 Gew.-% und die Kornverteilung des Magnesiamehls entspricht z.B. einer Gaußschen Kornverteilung.
- Das Siliciumcarbidmehl hat eine Reinheit von über 90 Gew.-%, insbesondere über 94 Gew.-% und weist vorzugsweise eine Gaußsche Kornverteilung auf.
- Die Kieselsäure ist mindestens ein Quarzmehl mit einer Korngröße unter 500 µm und/oder mindestens eine pyrogene Kieselsäure und/oder mindestens eine gefällte Kieselsäure und/oder mindestens ein Kieselrauch.
- Der Versatz weist mindestens ein Zusatzmittel aus der folgenden Gruppe auf:
   Verflüssiger, z. B. Castament (FS20), Hersteller BASF oder Dolapix (FF44), Hersteller Zschimmer und Schwarz
- Der Versatz weist mindestens ein Zuschlagstoffgranulat und/oder einen Zusatzstoff aus der folgenden Gruppe auf:
   Magnesiachromit, Magnesiaspinelle, Spinelle, Chromoxid, Zirkonoxid, Siliciumnitrid, Zirkon
- Offenbart wird auch ein vorteilhaftes, nicht erfindungsgemäßes Verfahren zur Herstellung eines feuerfesten Erzeugnisses unter Verwendung eines oben genannten Versatzes ohne Bindemittel, wobei ein Versatz mit Wasser zu einer wässrigen Masse gemischt wird, die Masse in eine Form eingebracht und zu einem Formkörper geformt und anschließend die Masse des Formkörpers sich erhärten gelassen und der Formkörper getrocknet wird, insbesondere bis zu einer maximalen Restfeuchte zwischen 0,1 und 4,5 Gew.-%.
- Für gepresste Erzeugnisse erfolgt das Erhärten und Trocknen bei Temperaturen zwischen 50 und 200°C, insbesondere zwischen 100 und 150°C.
- Für monolithische Fertigbauteile und Gießmassen erfolgt das Erhärten zwischen 15 und 35°C und das Trocknen bei Temperaturen zwischen 50 und 200, insbesondere zwischen 100 und 150°C.
- Bei dem vorteilhaften, nicht erfindungsgemäßen Verfahren wird eine wasserhaltige Masse zu Formsteinen gepresst und die Formsteine werden erhärtet gelassen und getrocknet, wobei vorzugsweise die Formsteine in einem keramischen Brennofen keramisch gebrannt werden, insbesondere bei Temperaturen zwischen 1.000 und 1.300, vorzugsweise zwischen 1.150 und 1.250°C, in oxidierender Atmosphäre, vorzugsweise in reduzierender Atmosphäre, z. B. mit einer Brenndauer zwischen 4 und 8, insbesondere zwischen 5 und 8 Stunden.
- Beim erfindungsgemäßen Verfahren wird der Versatz in Kombination mit Wasser oder anstelle von Wasser mit mindestens einem wasserhaltigen Bindemittel für feuerfeste Erzeugnisse z. B. mit einer Menge von 1 bis 10 Gew.-% zu einer bildsamen Masse gemischt.
- Beim erfindungsgemäßen Verfahren wird der Versatz anstelle von Wasser mit mindestens einem Bindemittel aus der Gruppe Pech und/oder Teer und Kunstharze z. B. mit einer Menge von 2 bis 5 Gew.-% zu einer bildsamen Masse gemischt.
- Die Erfindung betrifft auch einen Formstein, hergestellt nach einem erfindungsgemäßen Verfahren, aufweisend eine Rohdichte zwischen 2,65 und 2,80 kg/m³ und eine Druckfestigkeit zwischen 25 und 50, insbesondere zwischen 35 und 45 MPa.

## Patentansprüche

1. Versatz aus mineralischen, feuerfesten Werkstoffen für eine Auskleidung von Buntmetall-Schmelzaggregaten, vorzugsweise für die Auskleidung von Kupferschmelzkonvertern, enthaltend über 90 Gew.-%, insbesondere über 95 Gew.-% eines Gemisches aus folgenden Bestandteilen oder ganz vorzugsweise bestehend aus folgenden Bestandteilen:
- 3 bis 74 Gew.-% mindestens eines grobkörnigen Olivinrohstoffs mit Forsteritgehalten von mindestens 70 Gew.-%, insbesondere mindestens 90 Gew.-%, vorzugsweise 100 Gew.-%, aufweisend Korngrößen von über 0,1 mm
- 25 bis 49 Gew.-% mindestens einer Magnesia in Mehlform mit Korngrößen ≤ 1 mm
- 0,9 bis 14 Gew.-% mindestens eines Siliciumcarbids (SiC) in Mehlform mit Korngrößen ≤ 1 mm
- 0,1 bis 10 Gew.-% mindestens einer feinteiligen trockenen pulverförmigen Kieselsäure, vorzugsweise mit Teilchengrößen ≤ 500 µm
- 0 bis 4 Gew.-% mindestens eines an sich bekannten Antioxidans für feuerfeste Erzeugnisse
- 0 bis 4 Gew.-% mindestens eines zusätzlichen feuerfesten Rohstoffgranulats aufweisend Korngrößen von über 0,1 mm
- 0 bis 2 Gew.-% mindestens eines Zusatzmittels für die Herstellung feuerfester Erzeugnisse aus Versätzen
- 0 bis 4 Gew.-% mindestens eines Zusatzstoffes aus feuerfesten Werkstoffen in Mehlform
- bis 10 Gew.-%, berechnet auf die Trockensubstanz des Versatzes, mindestens eines Bindemittels für feuerfeste Erzeugnisse in trockener Form oder beigepackt in flüssiger Form,
**dadurch gekennzeichnet, dass**
der Versatz mindestens ein wasserhaltiges Bindemittel für feuerfeste Erzeugnisse aus der Gruppe Ligninsulfonat, Magnesiumsulfat und Ethylsilikat und/oder
mindestens ein Bindemittel aus der Gruppe Pech und/oder Teer und Kunstharze aufweist.

2. Versatz nach Anspruch 1,
enthaltend über 90 Gew.-%, insbesondere über 95 Gew.-% eines der folgenden Gemische, vorzugsweise bestehend aus einem der folgenden Gemische:
- 21 bis 63,7 Gew.-% des mindestens einen genannten Olivinrohstoffs
- 30 bis 43 Gew.-% der mindestens einen Magnesia
- 5 bis 14 Gew.-% des mindestens einen Siliciumcarbids
- 0,5 bis 5 Gew.-% der mindestens einen Kieselsäure
- 0,5 bis 2,5 Gew.-% des mindestens einen Antioxidans
- 0,1 bis 3,5 Gew.-% des mindestens einen zusätzlichen feuerfesten Rohstoffgranulats
- 0,1 bis 1,5 Gew.-% des mindestens einen Zusatzmittels
- 0,1 bis 3,5 Gew.-% des mindestens einen Zusatzstoffs
- bis 5 Gew.-%, berechnet auf die Trockensubstanz des Versatzes, des mindestens einen Bindemittels.

3. Versatz nach Anspruch 1 oder 2,
**dadurch gekennzeichnet, dass**
der Versatz das wasserhaltige Bindemittel mit einer Menge von 1 bis 10 Gew.-%, berechnet auf die Trockensubstanz des Versatzes, aufweist.

4. Versatz nach einem der vorhergehenden Ansprüche,
**dadurch gekennzeichnet, dass**
der Versatz das Bindemittel aus der Gruppe Pech und/oder Teer und Kunstharze mit einer Menge von 2 bis 5 Gew.-%, berechnet auf die Trockensubstanz des Versatzes, aufweist.

5. Versatz nach einem oder mehreren der vorhergehenden Ansprüche,
**dadurch gekennzeichnet, dass**
der Olivinrohstoff ein natürlicher Olivinrohstoff und/oder ein synthetisch hergestellter Forsteritwerkstoff ist mit Kornbändern des Olivinrohstoffs im Grobkornbereich zwischen 0,1 und 6 mm, insbesondere zwischen 1 und 6 mm und vorzugsweise einer Gaußschen Kornverteilung.

6. Versatz nach einem oder mehreren der vorhergehenden Ansprüche,
**dadurch gekennzeichnet, dass**
der MgO-Gehalt des Magnesiamehls über 90 Gew.-%, insbesondere über 95 Gew.-% liegt und die Kornverteilung des Magnesiamehls z. B. einer Gaußschen Kornverteilung entspricht.

7. Versatz nach einem oder mehreren der vorhergehenden Ansprüche,
**dadurch gekennzeichnet, dass**
das Siliciumcarbidmehl eine Reinheit von über 90 Gew.-%, insbesondere über 94 Gew.-% hat und vorzugsweise eine Gaußsche Kornverteilung aufweist.

8. Versatz nach einem oder mehreren der vorhergehenden Ansprüche,
**dadurch gekennzeichnet, dass**
die Kieselsäure mindestens ein Quarzmehl mit einer Korngröße unter 500 µm und/oder mindestens eine pyrogene Kieselsäure und/oder mindestens eine gefällte Kieselsäure und/oder mindestens ein Kieselrauch ist.

9. Versatz nach einem oder mehreren der vorhergehenden Ansprüche,
**dadurch gekennzeichnet, dass**
der Versatz als Zusatzmittel einen Verflüssiger enthält.

10. Versatz nach einem oder mehreren der vorhergehenden Ansprüche,
**dadurch gekennzeichnet, dass**
mindestens ein Zuschlagstoffgranulat und/oder ein Zusatzstoff aus der folgenden Gruppe ausgewählt ist:
Magnesiachromit, Magnesiaspinelle, Spinelle, Chromoxid, Zirkonoxid, Siliciumnitrid, Zirkon.

11. Verfahren zur Herstellung eines feuerfesten Erzeugnisses unter Verwendung eines Versatzes nach einem oder mehreren der vorhergehenden Ansprüche,
**dadurch gekennzeichnet, dass**
der Versatz mit dem Bindemittel zu einer bildsamen Masse gemischt, die Masse in eine Form eingebracht und zu einem Formkörper geformt und anschließend die Masse des Formkörpers sich erhärten gelassen und der Formkörper getrocknet wird, insbesondere bis zu einer maximalen Restfeuchte zwischen 0,1 und 4,5 Gew.-%.

12. Verfahren nach Anspruch 11,
**dadurch gekennzeichnet, dass**
für gepresste Erzeugnisse das Erhärten und Trocknen bei Temperaturen zwischen 50 und 200°C, insbesondere zwischen 100 und 150°C erfolgt.

13. Verfahren nach Anspruch 11, **dadurch gekennzeichnet, dass**
für monolithische Fertigbauteile und Gießmassen das Erhärten zwischen 15 und 35°C und das Trocknen bei Temperaturen zwischen 50 und 200, insbesondere zwischen 100 und 150°C erfolgt.

14. Verfahren nach Anspruch 11, **dadurch gekennzeichnet, dass**
die bildsame Masse zu Formsteinen gepresst wird und die Formsteine erhärten gelassen und getrocknet werden, wobei vorzugsweise die Formsteine in einem keramischen Brennofen keramisch gebrannt werden, insbesondere bei Temperaturen zwischen 1.000 und 1.300, vorzugsweise zwischen 1.150 und 1.250°C, in oxidierender Atmosphäre, vorzugsweise in reduzierender Atmosphäre, z. B. mit einer Brenndauer zwischen 4 und 8, insbesondere zwischen 5 und 8 Stunden.

15. Verfahren nach einem oder mehreren der Ansprüche 11 bis 14,
**dadurch gekennzeichnet, dass**
der Versatz mit einer Menge von 1 bis 10 Gew.-%, berechnet auf die Trockensubstanz des Versatzes, des wasserhaltigen Bindemittels zu der bildsamen Masse gemischt wird.

16. Verfahren nach einem oder mehreren der Ansprüche 11 bis 14,
**dadurch gekennzeichnet, dass**
der Versatz in Kombination mit Wasser mit dem mindestens einen wasserhaltigen Bindemittel, z. B. mit einer Menge von 1 bis 10 Gew.-%, bezogen auf die Trockensubstanz des Versatzes, zu der bildsamen Masse gemischt wird.

17. Verfahren nach einem oder mehreren der Ansprüche 11 bis 14,
**dadurch gekennzeichnet, dass**
der Versatz mit einer Menge von 2 bis 5 Gew.-%, berechnet auf die Trockensubstanz des Versatzes, des Bindemittels aus der Gruppe Pech und/oder Teer und Kunstharze zu der bildsamen Masse gemischt wird.

18. Formstein hergestellt nach Anspruch 14,
wobei die Formsteine ungebrannt sind und eine Rohdichte zwischen 2,65 und 2,80 kg/m³ und eine Kaltdruckfestigkeit zwischen 40 und 100, insbesondere zwischen 60 und 80 MPa aufweisen.

19. Formstein hergestellt nach Anspruch 14,
wobei die Formsteine gebrannt sind und eine Rohdichte zwischen 2,55 und 2,75 kg/m³ und eine Kaltdruckfestigkeit zwischen 30 und 80, insbesondere zwischen 40 und 70 MPa aufweisen.

## Claims

1. A batch of mineral refractory materials for lining non-ferrous metal smelting units, preferably for lining copper smelting converters, containing greater than 90 wt%, in particular greater than 95 wt%, of a mix of the following constituents or very preferably consisting of the following constituents:
- 3 to 74 wt% of at least one coarse-grained olivine raw material with forsterite contents of at least 70 wt%, in particular at least 90 wt%, preferably 100 wt%, having grain sizes greater than 0.1 mm
- 25 to 49 wt% of at least one magnesia in flour form with grain sizes ≤ 1 mm
- 0.9 to 14 wt% of at least one silicon carbide (SiC) in flour form with grain sizes ≤ 1 mm
- 0.1 to 10 wt% of at least one fine-particle dry powder-form silica, preferably with particle sizes ≤ 500 µm
- 0 to 4 wt% of at least one antioxidant, known per se, for refractory products
- 0 to 4 wt% of at least one additional refractory
raw material granulate having grain sizes greater than 0.1 mm
- 0 to 2 wt% of at least one additive for the production of refractory products from batches
- 0 to 4 wt% of at least one admixture comprising refractory materials in flour form
- up to 10 wt%, calculated on the basis of the dry matter of the batch, of at least one binder for refractory products in dry form or included in liquid form,
**characterised in that**
the batch has at least one water-containing binder for refractory products from the group lignosulphonate, magnesium sulphate and ethyl silicate and/or
at least one binder from the group pitch and/or tar and synthetic resins.

2. The batch according to Claim 1,
containing greater than 90 wt%, in particular greater than 95 wt%, of one of the following mixes, preferably consisting of one of the following mixes:
- 21 to 63.7 wt% of the at least one said olivine raw material
- 30 to 43 wt% of the at least one magnesia
- 5 to 14 wt%. of the at least one silicon carbide
- 0.5 to 5 wt% of the at least one silica
- 0.5 to 2.5 wt% of the at least one antioxidant
- 0.1 to 3.5 wt% of the at least one additional refractory raw material granulate
- 0.1 to 1.5 wt% of the at least one additive
- 0.1 to 3.5 wt% of the at least one admixture
- up to 5 wt%, calculated on the basis of the dry matter of the batch, of the at least one binder.

3. The batch according to Claim 1 or 2,
**characterised in that**
the batch has the water-containing binder with a quantity of 1 to 10 wt%, calculated on the basis of the dry matter of the batch.

4. The batch according to one of the preceding claims,
**characterised in that**
the batch has the binder from the group pitch and/or tar and synthetic resins in a quantity of 2 to 5 wt%, calculated on the basis of the dry matter of the batch.

5. The batch according to one or more of the preceding claims,
**characterised in that**
the olivine raw material is a natural olivine raw material and/or a synthetically produced forsterite material with grain bands of the olivine raw material in the coarse-grain range between 0.1 and 6 mm, in particular between 1 and 6 mm, and preferably a Gaussian grain distribution.

6. The batch according to one or more of the preceding claims,
**characterised in that**
the MgO content of the magnesia flour is greater than 90 wt%, in particular greater than 95 wt%, and the grain distribution of the magnesia flour corresponds for example to a Gaussian grain distribution.

7. The batch according to one or more of the preceding claims,
**characterised in that**
the silicon carbide flour has a purity greater than 90 wt%, in particular greater than 94 wt%, and preferably a Gaussian grain distribution.

8. The batch according to one or more of the preceding claims,
**characterised in that**
the silica is at least one quartz flour with a grain size below 500 µm and/or at least one pyrogenic silica and/or at least one precipitated silica and/or at least one silica smoke.

9. The batch according to one or more of the preceding claims,
the batch contains a liquefier as an additive.

10. The batch according to one or more of the preceding claims,
**characterised in that**
at east one granular aggregate and/or admixture is selected from the following group:
magnesia chromite, magnesia spinel, spinel, chromium oxide, zirconium oxide, silicon nitride, zircon.

11. A method for producing a refractory product using a batch according to one or more of the preceding claims,
**characterised in that**
the batch is mixed with the binder to form a ductile compound, the compound is introduced into a mould and formed into a moulded body and the compound of the moulded body is subsequently left to harden and the moulded body is dried, in particular to a maximum residual moisture between 0.1 and 4.5 wt%.

12. The method according to Claim 11,
**characterised in that**,
for pressed products, the hardening and drying takes place at temperatures between 50 and 200°C, in particular between 100 and 150°C.

13. The method according to Claim 11,
**characterised in that**,
for monolithic prefabricated components and casting compounds, the hardening takes place between 15 and 35°C and the drying takes place at temperatures between 50 and 200°C, in particular between 100 and 150°C.

14. The method according to Claim 11,
**characterised in that**
the ductile mass is pressed to form moulded bricks and the moulded bricks are left to harden and are dried, wherein the moulded bricks are preferably ceramically fired in a ceramic furnace, in particular at temperatures between 1,000 and 3,000°C, preferably between 1,150 and 1,250°C, in an oxidising atmosphere, preferably in a reducing atmosphere, e.g. with a firing time between 4 and 8 hours, in particular between 5 and 8 hours.

15. The method according to one or more of Claims 11 to 14,
**characterized in that**
the batch is mixed with a quantity of 1 to 10 wt%, calculated on the basis of the dry matter of the batch, of the water-containing binder to form the ductile compound.

16. The method according to one or more of Claims 11 to 14
**characterised in that**
the batch, in combination with water, is mixed with the at least one water-containing binder, e.g. with a quantity of 1 to 10 wt%, based on the dry matter of the batch, to form the ductile compound.

17. The method according to one or more of Claims 11 to 14,
**characterised in that**
the batch is mixed with a quantity of 2 to 5 wt%, calculated on the basis of the dry matter of the batch, of the binder from the group pitch and/or tar and synthetic resins to form the ductile compound.

18. A moulded brick produced according to Claim 14,
wherein the moulded bricks are unfired and have a raw density between 2.65 and 2.80 kg/m³ and a cold compressive strength between 40 and 100 MPa, in particular between 60 and 80 MPa.

19. The moulded brick produced according to Claim 14,
wherein the moulded bricks are fired and have a raw density between 2.55 and 2.75 kg/m³ and a cold compressive strength between 30 and 80 MPa, in particular between 40 and 70 MPa.

## Revendications

1. Mélange composé de matériaux minéraux réfractaires pour le revêtement de fours de fusion de métaux non ferreux, de préférence pour le revêtement de convertisseurs de fusion de cuivre, contenant plus de 90 % en poids, en particulier plus de 95 % en poids d'un mélange composé de constituants suivants ou idéalement constitué de constituants suivants :
- 3 à 74 % en poids d'au moins une matière brute d'olivine à gros grains avec des teneurs en forstérite d'au moins 70 % en poids, en particulier d'au moins 90 % en poids, de préférence 100 % en poids, présentant des granulométries supérieures à 0,1 mm
- 25 à 49 % en poids d'au moins une magnésie sous forme de farine avec des granulométries ≤ 1 mm
- 0,9 à 14 % en poids d'au moins un carbure de silicium (SiC) sous la forme de farine avec des granulométries ≤ 1 mm
- 0,1 à 10 % en poids d'au moins un acide silicique pulvérulent sec à fines particules, de préférence avec des tailles de particules ≤ 500 µm
- 0 à 4 % en poids d'au moins un antioxydant connu en soi pour des produits réfractaires
- 0 à 4 % en poids d'au moins un granulat de matière brute réfractaire supplémentaire présentant des granulométries supérieures à 0,1 mm
- 0 à 2 % en poids d'au moins un additif pour la fabrication de produits réfractaires composés de mélanges
- 0 à 4 % en poids d'au moins un adjuvant composé de matériaux réfractaires sous forme de farine
- jusqu'à 10 % en poids, calculé sur la substance sèche du mélange, d'au moins un liant pour des produits réfractaires sous une forme sèche ou fournis sous une forme liquide,
**caractérisé en ce que**
le mélange présente au moins un liant contenant de l'eau pour des produits réfractaires issu du groupe sulfonate de lignine, sulfate de magnésium et silicate d'éthyle
et/ou
au moins un liant issu du groupe poix et/ou goudron et résines synthétiques.

2. Mélange selon la revendication 1,
contenant plus de 90 % en poids, en particulier plus de 95 % en poids d'un des mélanges suivants, de préférence constitué d'un des mélanges suivants :
- 21 à 63,7 % en poids de ladite au moins une matière brute d'olivine mentionnée
- 30 à 43 % en poids de ladite au moins une magnésie
- 5 à 14 % en poids dudit au moins un carbure de silicium
- 0,5 à 5 % en poids dudit au moins un acide silicique
- 0,5 à 2,5 % en poids dudit au moins un antioxydant
- 0,1 à 3,5 % en poids dudit au moins granulat de matière brute réfractaire supplémentaire
- 0,1 à 1,5 % en poids dudit au moins un additif
- 0,1 à 3,5 % en poids de dudit au moins un adjuvant
- jusqu'à 5 % en poids, calculé sur la substance sèche du mélange, dudit au moins un liant.

3. Mélange selon la revendication 1 ou 2,
**caractérisé en ce que**
le mélange présente le liant contenant de l'eau avec une quantité allant de 1 à 10 % en poids, calculée sur la substance sèche du mélange.

4. Mélange selon l'une quelconque des revendications précédentes,
**caractérisé en ce que**
le mélange présente le liant issu du groupe poix et/ou goudron et résines synthétiques avec une quantité allant de 2 à 5 % en poids calculée sur la substance sèche du mélange.

5. Mélange selon l'une quelconque ou plusieurs des revendications précédentes,
**caractérisé en ce que**
la matière brute d'olivine est une matière brute d'olivine naturelle et/ou un matériau de forstérite produit de façon synthétique, avec une granulométrie de l'olivine brute dans une plage granulométrique comprise entre 0,1 et 6 m, en particulier entre 1 et 6 mm et de préférence avec une répartition gaussienne des grains.

6. Mélange selon l'une quelconque ou plusieurs des revendications précédentes,
**caractérisé en ce que**
la teneur en MgO de la farine de magnésie est supérieure à 90 % en poids, en particulier supérieure à 95 % en poids et la répartition granulométrique de la farine de magnésie correspond par exemple à la répartition gaussienne des grains.

7. Mélange selon l'une quelconque ou plusieurs des revendications précédentes,
**caractérisé en ce que**
la farine de carbure de silicium a une pureté supérieure à 90 % en poids, en particulier supérieure à 94 % en poids et présente de préférence une répartition gaussienne des grains.

8. Mélange selon l'une quelconque ou plusieurs des revendications précédentes,
**caractérisé en ce que**
l'acide silicique est au moins une farine de quartz avec une granulométrie inférieure à 500 µm et/ou au moins un acide silicique pyrogène et/ou au moins un acide silicique précipité et/ou au moins une fumée de silice.

9. Mélange selon l'une quelconque ou plusieurs des revendications précédentes,
**caractérisé en ce que**
le mélange contient en tant qu'additif un fluidifiant.

10. Mélange selon l'une quelconque ou plusieurs des revendications précédentes,
**caractérisé en ce que**
au moins un granulat d'agrégats et/ou un adjuvant sont choisis parmi le groupe suivant :
chromite de magnésite, spinelle de magnésie, spinelle, oxyde de chrome, oxyde de zirconium, nitrure de silicium, zirconium.

11. Procédé servant à fabriquer un produit réfractaire avec utilisation d'un mélange selon l'une quelconque ou plusieurs des revendications précédentes,
**caractérisé en ce que**
le mélange est mélangé au liant en une masse malléable, la masse est introduite dans un moule et est moulée en un corps moulé et la masse du corps moulé est durcie immédiatement après et le corps moulé est séché, en particulier jusqu'à une humidité résiduelle maximale comprise entre 0,1 et 4,5 % en poids.

12. Procédé selon la revendication 11,
**caractérisé en ce que**
pour des produits pressés, le durcissement et le séchage sont effectués à des températures comprises entre 50 et 200 °C, en particulier entre 100 et 150 °C.

13. Procédé selon la revendication 11,
**caractérisé en ce que**
pour des éléments préfabriqués monolithiques et des masses de coulée, le durcissement est effectué entre 15 et 35 °C et le séchage est effectué à des températures comprises entre 50 et 200, en particulier entre 100 et 150 °C.

14. Procédé selon la revendication 11,
**caractérisé en ce que**
la masse malléable est pressée en des briques moulées et les briques moulées sont durcies et séchées, dans lequel de préférence les briques moulées sont obtenues par cuisson céramique dans un four céramique, en particulier à des températures comprises entre 1 000 et 1 300, de préférence entre 1 150 et 1 250 °C, sous une atmosphère oxydante, de préférence sous une atmosphère de réduction, par exemple pendant une durée de cuisson comprise entre 4 et 8, en particulier entre 5 et 8 heures.

15. Procédé selon l'une quelconque ou plusieurs des revendications 11 à 14,
**caractérisé en ce que**
le mélange est mélangé avec une quantité allant de 1 à 10 % en poids, calculée sur la substance sèche du mélange, du liant contenant de l'eau en la masse malléable.

16. Procédé selon l'une quelconque ou plusieurs des revendications 11 à 14,
**caractérisé en ce que**
le mélange est mélangé en combinaison avec de l'eau audit au moins un liant contenant de l'eau, par exemple avec une quantité allant de 1 à 10 % en poids, par rapport à la substance sèche du mélange, en la masse malléable.

17. Procédé selon l'une quelconque ou plusieurs des revendications 11 à 14,
**caractérisé en ce que**
le mélange est mélangé avec une quantité allant de 2 à 5 % en poids calculée sur la substance sèche du mélange, du liant issu du groupe poix et/ou goudron et résines synthétiques en la masse malléable.

18. Brique moulée fabriquée selon la revendication 14,
dans laquelle les briques moulées sont crues et présentent une masse volumique apparente comprise entre 2,65 et 2,80 kg/m³ et une résistance à la compression à froid comprise entre 40 et 100, en particulier entre 60 et 80 MPa.

19. Brique moulée fabriquée selon la revendication 14,
dans laquelle les briques moulées sont cuites et présentent une masse volumique apparente comprise entre 2,55 et 2,75 kg/m³ et présentent une résistance à la compression à froid comprise entre 30 et 80, en particulier entre 40 et 70 MPa.
